# EUROPEAN PATENT APPLICATION

(11) **EP 3 147 678 A1**
(43) Date of publication of application: **29.03.2017**
(21) Application number: 16179731.1
(22) Date of filing: 15.07.2016
(51) Int. Cl.: G01R 21/133, H02J 3/38

(54) **POWER MONITORING SYSTEM AND ASSOCIATED METHOD**

(30) Priority: 02.09.2015 KR 20150124505
(71) Applicant: LSIS Co., Ltd., Gyeonggi-do 14119 (KR)
(72) Inventor: SHON, Sang-Ki, Gyeonggi-do 14118 (KR)
(74) Representative: Zacco Sweden AB

(57) **Abstract**

A power monitoring system includes: an external power supply source (110); a renewable energy source (140); a distribution board (120); a first power measuring device (151); a second power measuring device (152); a third power measuring device (153); and a server (10).

## Description

### BACKGROUND

### 1. Technical Field

The present invention relates to a system and method for monitoring power.

### 2. Description of the Related Art

With advance, convergence and integration of digital and network technologies, home appliances and information appliances having a variety of functions have been developed and spread widely in homes and offices. However, due to convergence and integration of functions and support of networking functions, such home appliances and information appliances consume their standby power while users are not aware of it, unlike power consumption at a request from the users and intentions of the users.

However, the users may not feel the necessity for electric energy saving since they cannot know how much power their own devices consume during a specific period of time.

To solve such a problem, there has been proposed a technique for analyzing and monitoring the amount and form of power consumption for a specified period determined for each electronic apparatus by means of a measuring device which measures the total amount of power consumed in the unit of home and building in connection with an energy consumption monitoring function for each electronic apparatus.

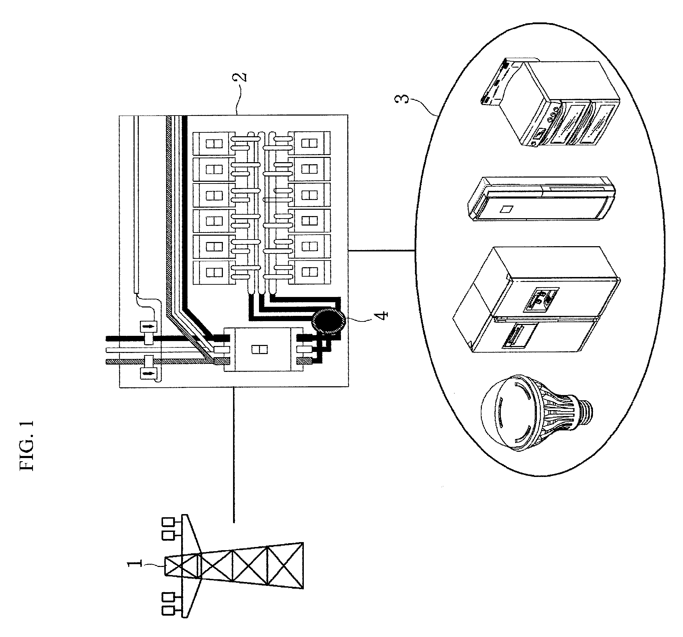

Fig. 1 is a block diagram illustrating the configuration of a conventional load power monitoring system.

Referring to Fig. 1, the conventional load power monitoring system may supply power, which is to be supplied from an external power supply source 1 to each home 3, to home appliances connected to electric outlets through a distribution board 2 installed in each home 3. In particular, the distribution board 2 has a power measuring device 4 for checking the state and amount of power consumption to know how the power supplied from the external power supply source 1 is used in the home appliances in the home 3.

The power measuring device 4 can use information on the power consumption amount and pattern of the home appliances to execute individual monitoring through a remote server.

There is a recent increasing trend that a power generation source or an energy source in addition to the external power supply source 1 is used to supply power to the home appliances in the home 3. A renewable energy source such as a solar power generator may be representative of the power generation source or the energy source in addition to the external power supply source 1.

However, when the renewable energy source is connected to the conventional load power monitoring system for supplying power, it is impossible to sense the amount of power additionally supplied from the renewable energy source. Therefore, from a user standpoint, in consideration of the amount of power additionally introduced from the renewable energy source in addition to the home appliances in the home 3, there is a problem that production and consumption of power in the home cannot be monitored in a collective manner.

### SUMMARY

It is an aspect of the present invention to provide a power monitoring system and method which is capable of collectively monitoring the state of consumption of power supplied to loads and the state of power production of a renewable energy source when the renewable energy source is applied in addition to the existing external power supply source.

In accordance with one aspect of the present invention, there is provided a power monitoring system including: an external power supply source configured to generate and supply power; a renewable energy source configured to generate and supply power; a distribution board configured to distribute power, which is applied from at least one of the external power supply source and the renewable energy source, to loads; a first power measuring device connected to an output terminal of the external power supply source and configured to sense first power amount data applied from the external power supply source to the distribution board; a second power measuring device connected to an input terminal of the distribution board and configured to sense second power amount data applied from the distribution board to the loads; a third power measuring device connected to an output terminal of the renewable energy source and configured to sense third power amount data applied from the renewable energy source to the distribution board; and a server configured to monitor power based on at least one of the first power amount data and the third power amount data, and the second power amount data.

In accordance with another aspect of the present invention, there is provided a power monitoring system including: an external power supply source configured to generate and supply power; a distribution board configured to distribute power, which is applied from the external power supply source, to loads; a renewable energy source connected to an output terminal of the distribution board and configured to generate power and apply the generated power to the loads through the distribution board; a first power measuring device connected to an output terminal of the external power supply source and configured to sense first power amount data including at least one of the amount of power applied from the external power supply source and the amount of power distributed to the loads; a second power measuring device connected to an input terminal of the distribution board and configured to sense second power amount data including at least one of the amount of power applied from the external power supply source and the amount of power distributed to the loads; a third power measuring device connected to an output terminal of the renewable energy source and configured to sense third power amount data applied from the renewable energy source; and a server configured to monitor power based on at least one of the first power amount data and the second power amount data, and the third power amount data.

### BRIEF DESCRIPTION OF DRAWINGS

Fig. 1 is a block diagram illustrating the configuration of a conventional load power monitoring system.
Fig. 2 is a block diagram illustrating the configuration of a load power monitoring system according to one embodiment of the present invention.
Figs. 3 to 5 are flow charts for explaining a power monitoring method of the load power monitoring system according to one embodiment of the present invention.
Fig. 6 is a block diagram illustrating the configuration of a load power monitoring system according to another embodiment of the present invention.
Figs. 7 to 9 are flow charts for explaining a power monitoring method of the load power monitoring system according to one embodiment of the present invention.
Fig. 10 is a block diagram illustrating the configuration of a monitoring server according to one embodiment of the present invention.
Fig. 11 is a flow chart for explaining a power monitoring result output operation according to one embodiment of the present invention.
Fig. 12 is a graph showing examples of the power monitoring result output according to one embodiment of the present invention.

### DETAILED DESCRIPTION

Hereinafter, embodiments of the present invention will be described in detail with reference to the accompanying drawings. It should be understood that the present invention is not limited to the following embodiments, and that the embodiments are provided for illustrative purposes only. The scope of the invention should be defined only by the accompanying claims and equivalents thereof.

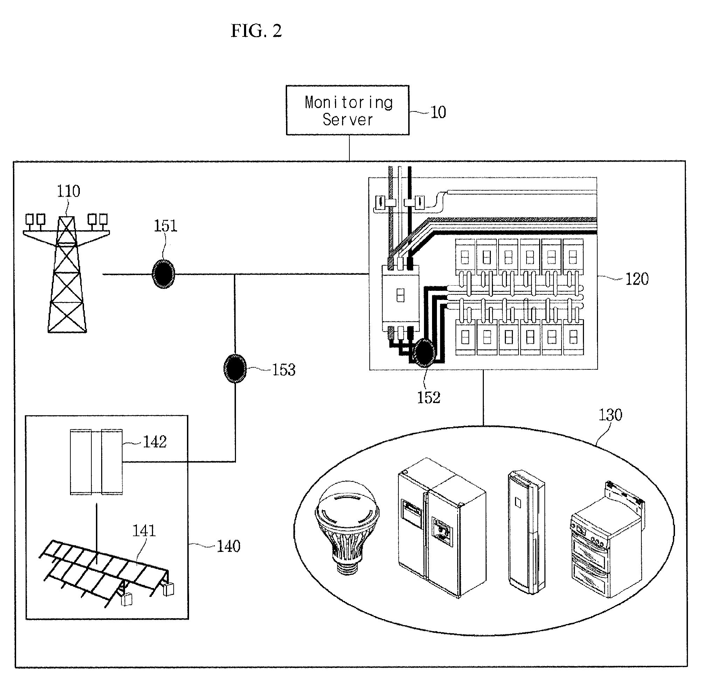

Fig. 2 is a block diagram illustrating the configuration of a load power monitoring system according to one embodiment of the present invention.

Referring to Fig. 2, the load power monitoring system according to one embodiment of the present invention includes a monitoring server 10, an external power supply source 110, a distribution board 120, electronic apparatuses 130 and a solar power generator 140. In particular, the load power monitoring system may be configured to include power measuring devices 151, 152 and 153, which are installed at output terminals or input terminals of the external power supply source 110, the distribution board 120 and the solar power generator 140, for monitoring and measuring power amount data introduced or output into the external power supply source 110, the distribution board 120 and the solar power generator 140.

Although a renewable energy source is illustrated with the solar power generator in one embodiment of the present invention, the present invention is not limited thereto but may be applied to any renewable energy sources as long as they can produce and supply power. The monitoring server 10 can acquire power amount data including power consumption and introduction amount of loads and power sources measured from the power measuring devices 151, 152 and 153 or their power consumption patterns. In addition, based on the acquired data, the monitoring server 10 can monitor the overall supply power of the system, the overall power consumption of the system, and the power consumption and operation state of individual loads in the system.

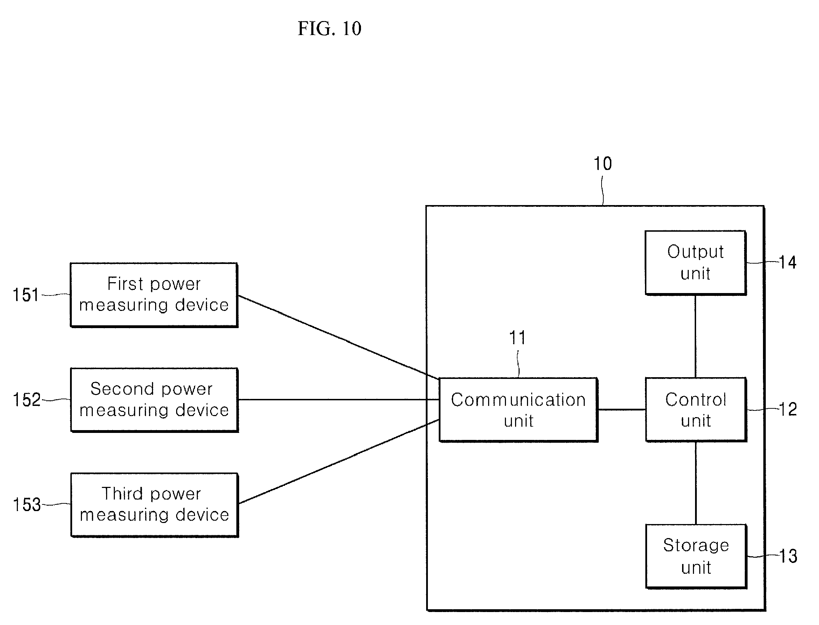

Fig. 10 is a block diagram illustrating the configuration of the monitoring server 10 according to one embodiment of the present invention.

Referring to Fig. 10, the monitoring server 10 according to the embodiment of the present invention may be configured to include a communication unit 11, a control unit 12, a storage unit 13 and an output unit 14.

The communication unit 11 may include one or more modules for facilitating wireless or wired communication with the power measuring devices 151, 152 and 153 or external devices.

The communication unit 11 may be configured with wireless Internet modules in which WLAN (Wireless LAN) (or Wi-Fi), Wibro (Wireless broadband), Wimax (World Interoperability for Microwave Access), HSDPA (High Speed Downlink Packet Access) and the like are used. In addition, the communication unit 11 may be configured with a variety of forms of LAN modules and wired communication modules in which Bluetooth, RFID (Radio Frequency Identification), IrDA (Infrared Data Association), UWB (Ultra Wideband), Zigbee and the like are used. The communication unit 11 can receive power amount data from at least one of the power measuring devices 151, 152 and 153.

The power amount data used herein may include a power introduction amount, a power consumption amount, a power consumption pattern, and a power consumption pattern of an individual load.

The control unit 12 can use the power amount data received from the power measuring devices 151, 152 and 153 via the communication unit 11 to monitor the power of the system.

Specifically, the control unit 12 can use the power amount data received from the power measuring devices 151, 152 and 153 to acquire at least one of the power introduction amount, the power consumption amount and the power consumption pattern.

In addition, the control unit 12 can extract a power consumption pattern of an individual load from the received power consumption data and can use the extracted power consumption pattern of the individual load to acquire an operation state and power consumption amount of the individual load.

In the meantime, the control unit 12 can use an NILM (Non-Intrusive Load Monitoring) algorithm to analyze a power consumption pattern. Specifically, upon receiving the power amount data from the power measuring devices, the control unit 12 can acquire at least one of the power introduction amount, the power consumption amount, the power consumption pattern, the operation state of the individual load, and the power consumption amount of the individual load by using the NILM algorithm to analyze the received power amount data. The NILM algorithm used herein refers to an algorithm capable of measuring a power consumption amount of an individual load, which is connected to a particular point at which power is supplied, by using data measured at the particular point.

In addition, the control unit 12 can store the received power amount data, a result obtained by analyzing the received power amount data, and information on the corresponding power measuring device in the storage unit 13 or output them through the output unit 14.

The storage unit 13 can store an algorithm for analysis on a pattern of power use, which is executed by the control unit 12. Examples of the storage unit 13 may include at least one of a flash memory, hard disk, multimedia card micro, a cord memory (such as A SD memory, an XD memory or the like), RAM (Random Access Memory), SRAM (Static RAM), ROM (Read-Only Memory), EEPROM (Electrically Erasable Programmable ROM), PROM (Programmable ROM), magnetic memory, magnetic disk and optical disk.

The output unit 14 can output a result of the analysis on the power amount data in a variety of forms of video, audio and so on. Examples of the output unit 14 may include a display, a speaker and so on.

The load power monitoring system may include a user input unit (not shown). Based on an input from a user through the user input unit, the load power monitoring system can control the monitoring server 10 or output at least one of the power introduction amount, the power consumption amount, the power consumption pattern, the operation state of the individual load, and the power consumption amount of the individual load.

Return to Fig. 2, as described above, the load power monitoring system according to the embodiment of the present invention may include the external power supply source 110, the distribution board 120, the load 130 and the solar power generator 140. In the following description, the load 130 will be described with an electronic apparatus. However, the load 130 is not limited thereto but may refer to any apparatuses as long as they can receive and consume power.

The external power supply source 110 is an external power generation source such as a power plant. Power introduced from the external power supply source 110 can be supplied to a variety of loads including home electronic apparatuses 130 through the distribution board 120.

The distribution board 120 can distribute power introduced from the external power supply source 110 or the solar power generator 140 such that the power is applied to a variety of loads including home electronic apparatuses 130.

The solar power generator 140 may be configured to include a solar module 141 and a control module 142. The control module 142 can convert solar energy, which is incident into the solar module 141 of the solar power generator 140, into AC power which is then supplied to the distribution board 120. Although a renewable energy source is illustrated with the solar power generator 140 in the embodiment of the present invention, the renewable energy source is not limited thereto but may be any power generators capable of generating a variety of renewable energy such as wind power, water power and the like.

The power measuring devices 151, 152 and 153 may be respectively connected to an output terminal of the external power supply source 110, an input terminal of the distribution board 120 and an output terminal of the solar power generator 140.

The first power measuring device 151 connected to the output terminal of the external power supply source 110 may be configured with at least one module capable of measuring a power amount supplied from the external power supply source 110.

In addition, when the power introduced from the external power supply source 110 is supplied to a plurality of loads such as the home electronic appliances 130, the first power measuring device 151 may be configured with at least one module capable of measuring the overall power consumption amount and the overall power consumption pattern of the plurality of loads.

In addition, the first power measuring device 151 may measure a power consumption pattern of each of the plurality of loads. The power consumption pattern of each of the plurality of loads can be used to acquire at least one of a power consumption amount of each of the plurality of loads and an operation state of each of the plurality of loads by later being analyzed by using the NILM algorithm.

When the power introduced from at least one of the external power supply source 110 and the solar power generator 140 is supplied to a plurality of loads such as the home electronic appliances 130, the second power measuring device 152 connected to the input terminal of the distribution board 120 may be configured with at least one module capable of measuring the overall power consumption amount of the plurality of loads. Specifically, the second power measuring device 152 connected to the input terminal of the distribution board 120 can sense second power amount data which are distributed from the distribution board 120 to the home electronic appliances 130.

In addition, the second power measuring device 152 may measure a power consumption pattern of each of the plurality of loads. The power consumption pattern of each of the plurality of loads can be used to acquire at least one of a power consumption amount of each of the plurality of loads, an operation state of each of the plurality of loads and a power consumption pattern of each of the plurality of loads by later being analyzed by using the NILM algorithm.

In addition, the third power measuring device 153 connected to the output terminal of the solar power generator 140 may be configured with at least one module capable of measuring the amount of power generated by the solar power generator 140.

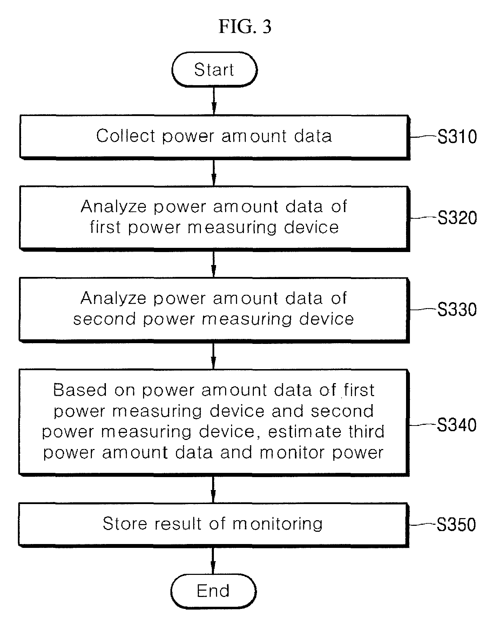

A method for monitoring load power according to one embodiment will now be described in detail with reference to Figs 3 to 5, based on the configuration of the power monitoring system including the power measuring devices as described above. In the following description, the monitoring method will be described with a limited order of data collection. However, it is to be understood that data may be collected from each power measuring device irrespective of the data collection order.

Figs. 3 to 5 are flow charts for explaining a power monitoring method of the load power monitoring system according to one embodiment of the present invention.

Fig. 3 is a flow chart for explaining a method for monitoring power using the first power amount data sensed by the first power measuring device and the second power amount data sensed by the second power measuring device in the monitoring server 10.

Referring to Fig. 3, the monitoring server 10 may collect power amount data from the first power measuring device 151 and the second power measuring device 152 through the communication unit 11 (S310). Specifically, the monitoring server 10 may receive the first power amount data from the first power measuring device 151 connected to the output terminal of the external power supply source 110. In addition, the monitoring server 10 may receive the second power amount data from the second power measuring device 152 connected to the input terminal of the distribution board 120.

It is illustrated in Fig. 2 that the third power measuring device 153 is connected to the output terminal of the solar power generator 140. However, the third power amount data of the third power measuring device 153 can be estimated based on the first power amount data and the second power amount data. Therefore, the power can be monitored without using the third power amount data.

The control unit 12 of the monitoring server 10 may analyze the first power amount data of the first power measuring device 151 which are collected through the communication unit 11 (S320).

In this case, information on the amount of power applied from the external power supply source 110 may be contained in the first power amount data.

In addition, if there is no current supplied from the solar power generator 140, the first power amount data may contain the total power consumption amount of the plurality of electronic apparatuses 130, the total power consumption pattern of the plurality of electronic apparatuses 130 and a power consumption pattern of an individual electronic apparatus.

The control unit 12 of the monitoring server 10 may analyze the second power amount data received from the second power measuring device 152 (S330).

In this case, the second power amount data may contain information on the amount of power applied from at least one of the external power supply source 110 and the solar power generator 140 to the distribution board 120.

In addition, the second power amount data may contain the total power consumption amount of the plurality of electronic apparatuses 130, the total power consumption pattern of the plurality of electronic apparatuses 130 and a power consumption pattern of an individual electronic apparatus.

In addition, based on the first power amount data sensed by the first power measuring device 151 and the second power amount data sensed by the second power measuring device 152, the control unit 12 of the monitoring server 10 may estimate power amount data of the third power measuring device 153 and monitor the power of the system (S340).

The control unit 12 of the monitoring server 10 can monitor the system power based on the first power amount data sensed by the first power measuring device 151 and the second power amount data sensed by the second power measuring device 152.

Specifically, the control unit 12 can use the first power amount data sensed by the first power measuring device 151 to acquire the amount of power applied from the external power supply source 110. In addition, the control unit 12 can use the second power amount data sensed by the second power measuring device 152 to acquire at least one of the total power consumption amount of the plurality of electronic apparatuses 130, an amount of power consumed by an individual electronic apparatus, and an operation state of an individual electronic apparatus. In this case, the NILM algorithm may be used.

The control unit 12 may use the first power amount data of the first power measuring device 151 and the second power amount data of the second power measuring device 152 to estimate the third power amount data of the third power measuring device 153. Specifically, the control unit 12 can calculate the third power amount data of the third power measuring device 153 based on a difference (-) between the first power amount data of the first power measuring device 151 and the second power amount data of the second power measuring device 152. More Specifically, the control unit 12 can calculate the amount of power generated by the solar power generator 140 (the third power amount data) when calculating a difference (-) between the amount of power introduced from the external power supply source 110 (the first power amount data) and the amount of power consumed by the electronic apparatuses 130 (the second power amount data).

As described above, the control unit 12 can check the power amount data containing the amount of introduced power and the amount of consumed power of each of the first power measuring device 151 and the second power measuring device 152 and estimate the third power amount data containing the amount of generated power for a renewable energy source such as the solar power generator 140 based on the checked power amount data.

Accordingly, the control unit 12 can use the first power amount data, the second power amount data and the third power amount data estimated based on the first power amount data and the second power amount data to monitor the overall power of the system.

Although it is illustrated in this embodiment that, upon receiving the power amount data from the first power measuring device 151 or the second power measuring device 152, the control unit 12 of the monitoring server 10 analyzes the received power amount data to acquire at least one of the total power consumption amount of the plurality of electronic apparatuses 130, the amount of power consumed by the individual electronic apparatuses and the operation state of the individual electronic apparatuses, the present invention is not limited thereto.

For example, the first power measuring device 151 or the second power measuring device 152 may use the sensed power amount data to directly acquire at least one of the total power consumption amount of the plurality of electronic apparatuses 130, the amount of power consumed by the individual electronic apparatuses and the operation state of the individual electronic apparatuses, and may transmit the acquired information to the monitoring server 10.

The control unit 12 may store a monitoring result obtained based on the first power amount data, the second power amount data, the third power amount data and the power amount data in the storage unit 13 (S350).

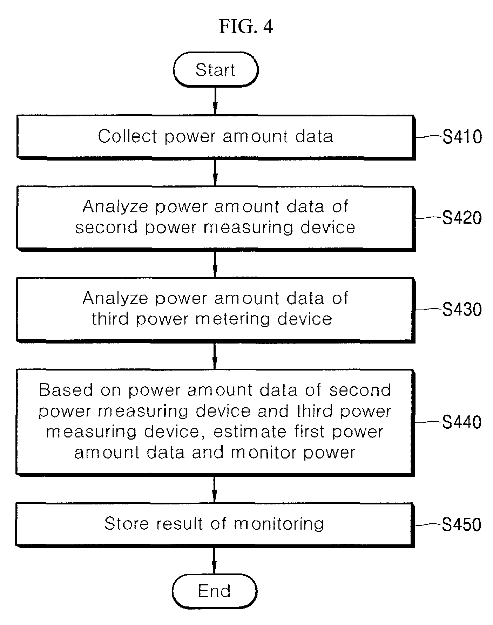

Fig. 4 is a flow chart for explaining a method for monitoring power using the second power amount data sensed by the second power measuring device and the third power amount data sensed by the third power measuring device in the monitoring server 10.

Referring to Fig. 4, the monitoring server 10 may collect power amount data through the communication unit 11 (S410). Specifically, the monitoring server 10 may receive the second power amount data from the second power measuring device 152 connected to the input terminal of the distribution board 120. In addition, the monitoring server 10 may receive the third power amount data from the third power measuring device 153 connected to the output terminal of the solar power generator 140.

It is illustrated in Fig. 2 that the first power measuring device 151 is connected to the output terminal of the external power supply source 110. However, the first power amount data of the first power measuring device 151 can be estimated based on the second power amount data and the third power amount data. Therefore, the power can be monitored without using the first power amount data.

The control unit 12 of the monitoring server 10 may analyze the second power amount data of the second power measuring device 152 which are collected through the communication unit 11 (S420).

In this case, the second power amount data may contain information on the amount of power applied from at least one of the external power supply source 110 and the solar power generator 140 to the distribution board 120.

In addition, the second power amount data may contain the total power consumption amount of the plurality of electronic apparatuses 130, the total power consumption pattern of the plurality of electronic apparatuses 130 and a power consumption pattern of an individual electronic apparatus.

The control unit 12 of the monitoring server 10 may analyze the third power amount data of the third power measuring device 153, which are collected through the communication unit 11 (5430).

In this case, the third power amount data may contain the amount of power generated by the solar power generator 140.

In addition, based on the second power amount data sensed by the second power measuring device 152 and the third power amount data sensed by the third power measuring device 153, the control unit 12 of the monitoring server 10 may estimate power amount data of the first power measuring device 151 and monitor the overall power of the system (S440).

The control unit 12 of the monitoring server 10 can monitor the system power based on the second power amount data sensed by the second power measuring device 152 and the third power amount data sensed by the third power measuring device 153.

Specifically, the control unit 12 can use the second power amount data sensed by the second power measuring device 152 to acquire the amount of power applied from at least one of the external power supply source 110 and the solar power generator 140. In addition, the control unit 12 can use the second power amount data sensed by the second power measuring device 152 to acquire at least one of the total power consumption amount of the plurality of electronic apparatuses 130, an amount of power consumed by an individual electronic apparatus, and an operation state of an individual electronic apparatus. In addition, the control unit 12 can use the third power amount data sensed by the third power measuring device 153 to acquire the amount of power generated by the solar power generator 140. In this case, the NILM algorithm may be used.

In addition, the control unit 12 may use the third power amount data of the third power measuring device 153 and the second power amount data of the second power measuring device 152 to estimate the first power amount data of the first power measuring device 151.

Specifically, the control unit 12 can estimate the first power amount data of the first power measuring device 151 based on a difference (-) between the third power amount data of the third power measuring device 153 and the second power amount data of the second power measuring device 152. More Specifically, the control unit 12 can calculate the amount of power introduced from the external power supply source 110 (the first power amount data) when calculating a difference (-) between the amount of power consumed by the electronic apparatuses 130 through the distribution board 120 (the second power amount data) and the amount of power generated by the solar power generator 140 (the third power amount data).

Accordingly, the control unit 12 can use the second power amount data, the third power amount data and the first power amount data estimated based on the second power amount data and the third power amount data to monitor the overall power of the system.

Although it is illustrated in this embodiment that, upon receiving the power amount data from the second power measuring device 152 or the third power measuring device 153, the control unit 12 of the monitoring server 10 analyzes the received power amount data to acquire at least one of the total power consumption amount of the plurality of electronic apparatuses 130, the amount of power consumed by the individual electronic apparatuses and the operation state of the individual electronic apparatuses, the present invention is not limited thereto.

For example, the second power measuring device 152 or the third power measuring device 153 may use the sensed power amount data to directly acquire at least one of the total power consumption amount of the plurality of electronic apparatuses 130, the amount of power consumed by the individual electronic apparatuses and the operation state of the individual electronic apparatuses, and may transmit the acquired information to the monitoring server 10.

The control unit 12 may store a monitoring result obtained based on the first power amount data, the second power amount data, the third power amount data and the power amount data in the storage unit 13 (S450).

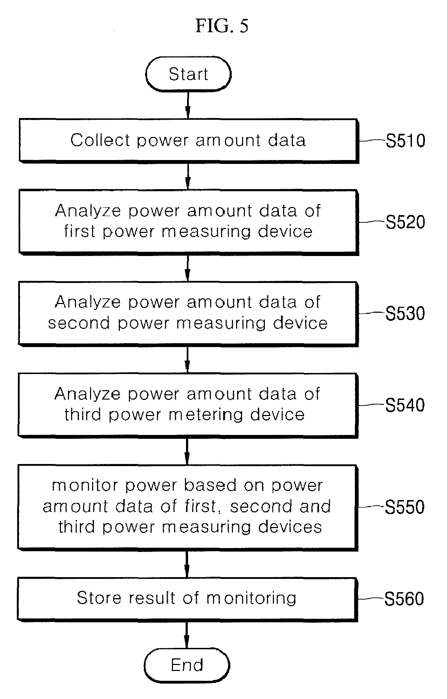

Fig. 5 is a flow chart for explaining a method for monitoring power using the first power amount data sensed by the first power measuring device, the second power amount data sensed by the second power measuring device and the third power amount data sensed by the third power measuring device in the monitoring server 10.

Referring to Fig. 5, the monitoring server 10 may collect power amount data through the communication unit 11 (S510). Specifically, the monitoring server 10 may receive the first power amount data from the first power measuring device 151 connected to the output terminal of the external power supply source 110. In addition, the monitoring server 10 may receive the second power amount data from the second power measuring device 152 connected to the input terminal of the distribution board 120. In addition, the monitoring server 10 may receive the third power amount data from the third power measuring device 153 connected to the output terminal of the solar power generator 140.

The control unit 12 of the monitoring server 10 may analyze the first power amount data of the first power measuring device 151, the second power amount data of the second power measuring device 152 and the third power amount data of the third power measuring device 153, which are collected through the communication unit 11 (S520, S530 and S540).

A method for analyzing the first power amount data of the first power measuring device 151, the second power amount data of the second power measuring device 152 and the third power amount data of the third power measuring device 153 is the same as illustrated in Figs. 3 and 4 and, therefore, explanation of which will not be repeated for the purpose of brevity.

The control unit 12 of the monitoring server 10 may monitor the overall power of the system based on the first power amount data sensed by the first power measuring device 151, the second power amount data sensed by the second power measuring device 152 and the third power amount data sensed by the third power measuring device 153 (S550).

Specifically, the control unit 12 can use the first power amount data sensed by the first power measuring device 151 to acquire the amount of power applied from the external power supply source 110. In addition, the control unit 12 can use the second power amount data sensed by the second power measuring device 152 to acquire at least one of the total power consumption amount of the plurality of electronic apparatuses 130, an amount of power consumed by an individual electronic apparatus, and an operation state of an individual electronic apparatus. In addition, the control unit 12 can use the third power amount data sensed by the third power measuring device 153 to acquire the amount of power applied from the solar power generator 140. In this case, the NILM algorithm may be used.

The control unit 12 may store a monitoring result obtained based on the first power amount data, the second power amount data, the third power amount data and the power amount data in the storage unit 13 (S560).

In this way, the power monitoring system of the present invention can use the first power measuring device 151, the second power measuring device 152 and the third power measuring device 153 to detect all of the amount of power supplied from the external power supply source 110, the amount of power supplied from the solar power generator 140, the total power consumption amount of the plurality of electronic apparatuses 130, the amount of power consumed by the individual electronic apparatuses, and the operation state of the individual electronic apparatuses. Accordingly, the power monitoring system of the present invention is capable of collective monitoring for production and consumption of power.

In addition, in the present invention, even if one of the first power measuring device 151 and the third power measuring device 153 is not present, since the amount of power supplied from the external power supply source 110 or the amount of power produced by the renewable energy source 140 can be estimated, it is possible to perform collective monitoring for production and consumption of power irrespective of failure or repair of one of the first power measuring device 151 and the third power measuring device 153.

In addition, the power monitoring system of the present invention can use all of the first power measuring device 151, the second power measuring device 152 and the third power measuring device 153 to monitor the system power with a minimized error.

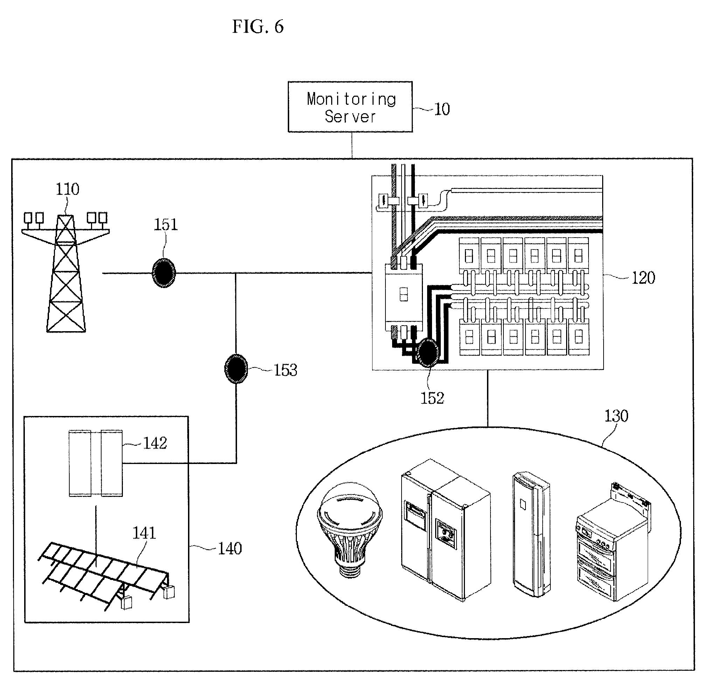

Fig. 6 is a block diagram illustrating the configuration of a load power monitoring system according to another embodiment of the present invention.

Referring to Fig. 6, the load power monitoring system according to another embodiment of the present invention includes a monitoring server 10, an external power supply source 110, a distribution board 120, electronic apparatuses 130 and a solar power generator 140. In particular, the load power monitoring system may be configured to include power measuring devices 161, 162 and 163, which are installed at output terminals or input terminals of the external power supply source 110, the distribution board 120 and the solar power generator 140, for monitoring and measuring power amount data introduced or output into the external power supply source 110, the distribution board 120 and the solar power generator 140.

The solar power generator 140 may be configured to include a solar module 141 and a control module 142. The control module 142 can convert solar energy, which is incident into the solar module 141 of the solar power generator 140, into AC power. In addition, the solar power generator 140 may be connected to an output terminal of the distribution board 120 so that the AC power can be supplied to the electronic apparatuses 130 through the distribution board 120.

The distribution board 120 can distribute power introduced from the external power supply source 110 such that the power is applied to a variety of loads including home electronic apparatuses 130. In addition, the AC power supplied from the solar power generator 140 can be applied to a variety of loads including the electronic apparatuses 130 through the distribution board 120.

The power measuring devices 161, 162 and 163 may be respectively connected to an output terminal of the external power supply source 110, an input terminal of the distribution board 120 and an output terminal of the solar power generator 140.

The first power measuring device 161 connected to the output terminal of the external power supply source 110 may be configured with at least one module capable of measuring a power amount supplied from the external power supply source 110.

In addition, when the power introduced from the external power supply source 110 is supplied to a plurality of loads such as the home electronic appliances 130, the first power measuring device 161 may be configured with at least one module capable of measuring the overall power consumption amount of the plurality of loads.

In addition, the first power measuring device 161 may measure a power consumption pattern of each of the plurality of loads. The power consumption pattern of each of the plurality of loads can be used to acquire at least one of a power consumption amount of each of the plurality of loads and an operation state of each of the plurality of loads by later being analyzed by using the NILM algorithm.

When the power introduced from the external power supply source 110 is supplied to a plurality of loads such as the home electronic appliances 130, the second power measuring device 162 connected to the input terminal of the distribution board 120 may be configured with at least one module capable of measuring the overall power consumption amount of the plurality of loads.

In addition, the second power measuring device 162 may measure a power consumption pattern of each of the plurality of loads. The power consumption pattern of each of the plurality of loads can be used to acquire at least one of a power consumption amount of each of the plurality of loads, an operation state of each of the plurality of loads and a power consumption pattern of each of the plurality of loads by using the NILM algorithm.

In addition, the third power measuring device 153 connected to the output terminal of the solar power generator 140 may be configured with at least one module capable of measuring the amount of power generated by the solar power generator 140.

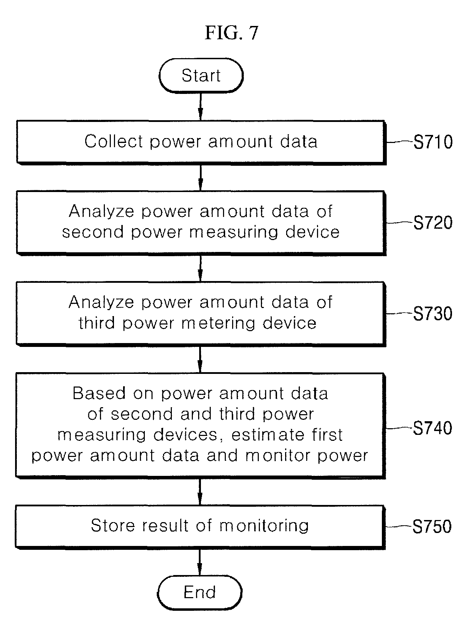

A method for monitoring load power according to one embodiment will now be described in detail with reference to Figs 7 to 9, based on the configuration of the power monitoring system including the power measuring devices as described above. In the following description, the monitoring method will be described with a limited order of data collection. However, it is to be understood that data may be collected from each power measuring device irrespective of the data collection order.

Figs. 7 to 9 are flow charts for explaining a power monitoring method of the load power monitoring system according to one embodiment of the present invention.

Fig. 7 is a flow chart for explaining a method for monitoring power using the second power amount data sensed by the second power measuring device and the third power amount data sensed by the third power measuring device in the monitoring server 10.

Referring to Fig. 7, the monitoring server 10 may collect power amount data through the communication unit 11 (S710). Specifically, the monitoring server 10 may receive the first power amount data from the first power measuring device 161 connected to the output terminal of the external power supply source 110. In addition, the monitoring server 10 may receive the third power amount data from the third power measuring device 163 connected to the output terminal of the solar power generator 140.

It is illustrated in Fig. 6 that the first power measuring device 161 is connected to the output terminal of the external power supply source 110. However, the first power amount data of the first power measuring device 161 can be estimated based on the second power amount data and the third power amount data. Therefore, the power can be monitored without using the first power amount data.

The control unit 12 of the monitoring server 10 may analyze the second power amount data of the second power measuring device 162 which are collected through the communication unit 11 (S720).

In this case, the second power amount data may contain information on the amount of power applied from the external power supply source 110 to the distribution board 120.

In addition, the second power amount data may contain the total power consumption amount of the plurality of electronic apparatuses 130, the total power consumption pattern of the plurality of electronic apparatuses 130 and a power consumption pattern of an individual electronic apparatus.

The control unit 12 of the monitoring server 10 may analyze the third power amount data of the third power measuring device 163, which are collected through the communication unit 11 (S730).

In this case, the third power amount data may contain the amount of power generated by the solar power generator 140 and applied to the electronic apparatuses 130.

In addition, based on the second power amount data sensed by the second power measuring device 162 and the third power amount data sensed by the third power measuring device 163, the control unit 12 of the monitoring server 10 may estimate power amount data of the first power measuring device 161 and monitor the overall power of the system (S740).

The control unit 12 of the monitoring server 10 can monitor the system power based on the second power amount data sensed by the second power measuring device 162 and the third power amount data sensed by the third power measuring device 163.

Specifically, the control unit 12 can use the second power amount data sensed by the second power measuring device 162 to acquire the amount of power applied from the external power supply source 110. In addition, the control unit 12 can use the second power amount data sensed by the second power measuring device 162 to acquire at least one of the total power consumption amount of the plurality of electronic apparatuses 130, an amount of power consumed by an individual electronic apparatus, and an operation state of an individual electronic apparatus. In this case, the NILM algorithm may be used.

In addition, the control unit 12 may use the third power amount data of the third power measuring device 163 to acquire information on the amount of power generated by the solar power generator 140.

In addition, the control unit 12 may use the third power amount data of the third power measuring device 163 and the second power amount data of the second power measuring device 162 to estimate the first power amount data of the first power measuring device 161. More Specifically, the control unit 12 can estimate the amount of power introduced from the external power supply source 110, that is, the first power amount data, when calculating a difference between the amount of power consumed by the electronic apparatuses 130, which is contained in the second power amount data, and the amount of power generated by the solar power generator 140, which is contained in the third power amount data.

Accordingly, the control unit 12 can use the second power amount data, the third power amount data and the first power amount data estimated based on the second power amount data and the third power amount data to monitor the overall power of the system.

The control unit 12 may store a monitoring result obtained based on the first power amount data, the second power amount data, the third power amount data and the power amount data in the storage unit 13 (S750).

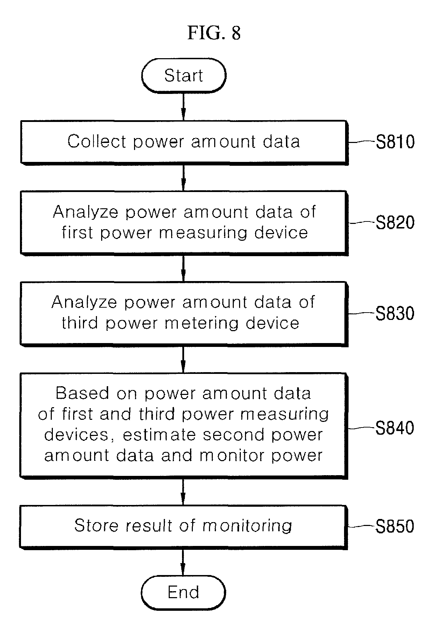

Fig. 8 is a flow chart for explaining a method for monitoring power using the first power amount data sensed by the first power measuring device and the third power amount data sensed by the third power measuring device in the monitoring server 10.

Referring to Fig. 8, the monitoring server 10 may collect power amount data through the communication unit 11 (S810). Specifically, the monitoring server 10 may receive the first power amount data from the first power measuring device 161 connected to the output terminal of the external power supply source 110. In addition, the monitoring server 10 may receive the third power amount data from the third power measuring device 163 connected to the output terminal of the solar power generator 140.

It is illustrated in Fig. 6 that the second power measuring device 162 is connected to the input terminal of the distribution board 120. However, the second power amount data of the second power measuring device 162 can be estimated based on the first power amount data and the third power amount data. Therefore, the power can be monitored without using the second power amount data.

The control unit 12 of the monitoring server 10 may analyze the first power amount data of the first power measuring device 152 which are collected through the communication unit 11 (S820).

In this case, the first power amount data may contain information on the amount of power applied from the external power supply source 110.

In addition, the first power amount data may contain the total power consumption amount of the plurality of electronic apparatuses 130, the total power consumption pattern of the plurality of electronic apparatuses 130 and a power consumption pattern of an individual electronic apparatus.

The control unit 12 of the monitoring server 10 may analyze the third power amount data received from the third power measuring device 163 (S830).

In this case, the third power amount data may contain the amount of power generated by the solar power generator 140.

In addition, based on the first power amount data sensed by the first power measuring device 161 and the third power amount data sensed by the third power measuring device 163, the control unit 12 of the monitoring server 10 may estimate power amount data of the second power measuring device 162 and monitor the system power (S840).

The control unit 12 of the monitoring server 10 can monitor the system power based on the first power amount data sensed by the first power measuring device 161 and the third power amount data sensed by the third power measuring device 163.

Specifically, the control unit 12 can use the first power amount data sensed by the first power measuring device 161 to acquire the amount of power applied from the external power supply source 110. In addition, the control unit 12 can use the first power amount data sensed by the first power measuring device 161 to acquire at least one of the total power consumption amount of the plurality of electronic apparatuses 130, an amount of power consumed by an individual electronic apparatus, and an operation state of an individual electronic apparatus. In addition, the control unit 12 can use the third power amount data sensed by the third power measuring device 163 to acquire the amount of power generated by the solar power generator 140. In this case, the NILM algorithm may be used.

In addition, the control unit 12 may use the first power amount data of the first power measuring device 161 and the third power amount data of the third power measuring device 163 to estimate the second power amount data of the second power measuring device 162. More Specifically, the control unit 12 can calculate the amount of power distributed from the distribution board 120 to the electronic apparatuses 130 when calculating the sum of the amount of power introduced from the external power supply source 110 (the first power amount data) and the amount of power generated by the solar power generator 140 (the third power amount data).

Accordingly, the control unit 12 can use the first power amount data, the third power amount data and the second power amount data estimated based on the first power amount data and the third power amount data to monitor the overall power of the system.

The control unit 12 may store a monitoring result obtained based on the first power amount data, the second power amount data, the third power amount data and the power amount data in the storage unit 13 (S850).

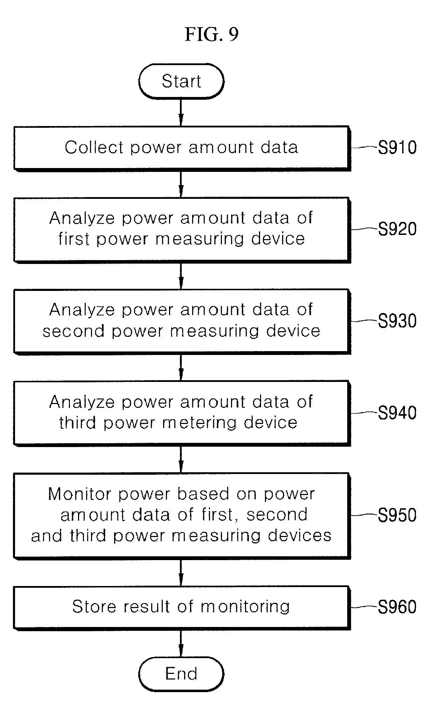

Fig. 9 is a flow chart for explaining a method for monitoring power using the first power amount data sensed by the first power measuring device, the second power amount data sensed by the second power measuring device and the third power amount data sensed by the third power measuring device in the monitoring server 10.

Referring to Fig. 9, the monitoring server 10 may collect power amount data through the communication unit 11 (S910). Specifically, the monitoring server 10 may receive the first power amount data from the first power measuring device 161 connected to the output terminal of the external power supply source 110. In addition, the monitoring server 10 may receive the second power amount data from the second power measuring device 162 connected to the input terminal of the distribution board 120. In addition, the monitoring server 10 may receive the third power amount data from the third power measuring device 163 connected to the output terminal of the solar power generator 140.

The control unit 12 of the monitoring server 10 may analyze the first power amount data of the first power measuring device 161, the second power amount data of the second power measuring device 162 and the third power amount data of the third power measuring device 163, which are collected through the communication unit 11 (S920, S930 and S940).

A method for analyzing the first power amount data of the first power measuring device 161, the second power amount data of the second power measuring device 162 and the third power amount data of the third power measuring device 163 is the same as illustrated in Figs. 7 and 8 and, therefore, explanation of which will not be repeated for the purpose of brevity.

The control unit 12 of the monitoring server 10 may monitor the overall power of the system based on the first power amount data sensed by the first power measuring device 161, the second power amount data sensed by the second power measuring device 162 and the third power amount data sensed by the third power measuring device 163 (S950).

Specifically, the control unit 12 can use the first power amount data sensed by the first power measuring device 161 to acquire the amount of power applied from the external power supply source 110. In addition, the control unit 12 can use the second power amount data sensed by the second power measuring device 162 to acquire at least one of the total power consumption amount of the plurality of electronic apparatuses 130, an amount of power consumed by an individual electronic apparatus, and an operation state of an individual electronic apparatus. In addition, the control unit 12 can use the third power amount data sensed by the third power measuring device 163 to acquire the amount of power applied from the solar power generator 140. In this case, the NILM algorithm may be used.

The control unit 12 may store a monitoring result obtained based on the first power amount data, the second power amount data, the third power amount data and the power amount data in the storage unit 13 (S960).

In this way, the power monitoring system of the present invention can use the first power measuring device 161, the second power measuring device 162 and the third power measuring device 163 to detect all of the amount of power supplied from the external power supply source 110, the amount of power supplied from the solar power generator 140, the total power consumption amount of the plurality of electronic apparatuses 130, the amount of power consumed by the individual electronic apparatuses, and the operation state of the individual electronic apparatuses. Accordingly, the power monitoring system of the present invention is capable of collective monitoring for production and consumption of power.

In addition, in the present invention, even if one of the first power measuring device 161 and the second power measuring device 162 is not present, since the amount of power supplied from the external power supply source 110 or the amount of power produced by the renewable energy source 140 can be estimated, it is possible to perform collective monitoring for production and consumption of power irrespective of failure or repair of one of the first power measuring device 161 and the second power measuring device 162.

In addition, the power monitoring system of the present invention can use all of the first power measuring device 161, the second power measuring device 162 and the third power measuring device 163 to monitor the system power with a minimized error.

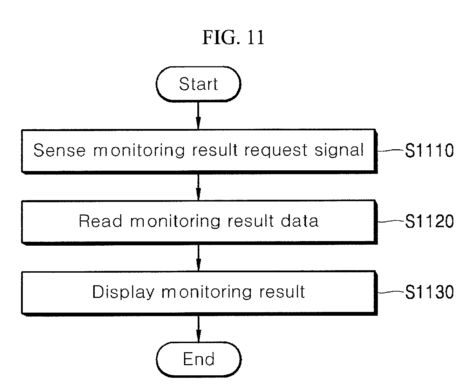

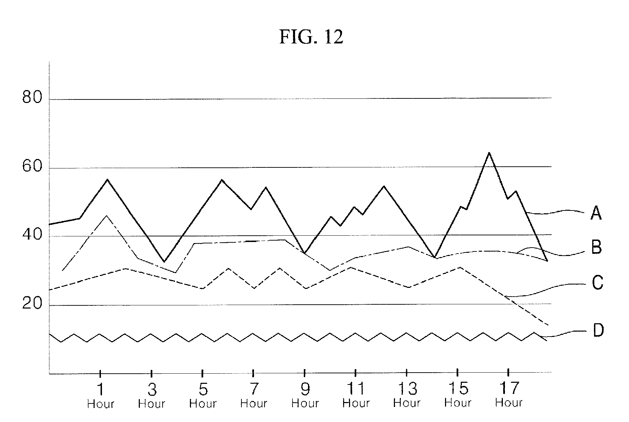

Fig. 11 is a flow chart for explaining a power monitoring result output operation according to one embodiment of the present invention. Fig. 12 is a graph showing examples of the power monitoring result output according to one embodiment of the present invention.

An operation for outputting a power monitoring result stored in the storage unit 13 of the monitoring server 10 according to one embodiment of the present invention will be described in detail below with reference to Figs. 11 and 12.

Referring to Figs. 11 and 12, the control unit 12 of the monitoring server 10 may detect an output request signal of the monitoring result which is measured, acquired and stored in the storage unit 13 according to the above embodiments of the present invention (S1110). The output request signal may be input through a user input unit (not shown) or may be received from a remote terminal or the like by wired or wireless.

The control unit 12 of the monitoring server 10 may read the monitoring result stored in the storage unit 13 (S1120) and may display power amount data in a variety of formats such as graph, numeric, text and so on as illustrated in Fig. 12 (S1130). Fig. 12 illustrates information on the amount of power consumption or electric charging of electronic apparatuses and a renewable energy source. In Fig. 12, "A" to "C" represent one example of the amount of power of the home electronic appliances 130 and "D" represents one example of the renewable energy source 140. It can be seen from Fig. 12 that a period of the amount of power for the home electronic appliances is short as power amount data required for an NILM analysis are sensed.

Although the operations for measuring or estimating the power amount data in the external power supply source 110, the distribution board 120, the electronic apparatuses 130 and the solar power generator 140 have been sequentially described in the above embodiments of the present invention, the sequence of the operations for measuring or estimating the power amount data is not particularly limited but may be changed in different formed.

With the power monitoring system and method according to the above embodiments of the present invention, when a renewable energy source is applied in addition to an external power supply source, it is possible to collectively monitor the state of consumption of power supplied to loads and the state of power production of the renewable energy source.

While certain embodiments have been described, these embodiments have been presented by way of example only, and are not intended to limit the scope of the disclosures. Indeed, the novel methods and apparatuses described herein may be embodied in a variety of other forms; furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A power monitoring system comprising:
an external power supply source (110) configured to generate and supply power;
a renewable energy source configured to generate and supply power;
a distribution board (120) configured to distribute power, which is applied from at least one of the external power supply source (110) and the renewable energy source, to loads;
a first power measuring device connected to an output terminal of the external power supply source (110) and configured to sense first power amount data applied from the external power supply source (110) to the distribution board (120);
a second power measuring device connected to an input terminal of the distribution board (120) and configured to sense second power amount data applied from the distribution board (120) to the loads;
a third power measuring device connected to an output terminal of the renewable energy source and configured to sense third power amount data applied from the renewable energy source to the distribution board (120); and
a server configured to monitor power based on at least one of the first power amount data and the third power amount data, and the second power amount data,
wherein the server collects the first power amount data and the second power amount data, estimates the third power amount data based on the collected power amount data, and monitors the power.

2. The power monitoring system according to claim 1, wherein the server collects the second power amount data and the third power amount data, estimates the first power amount data based on the collected power amount data, and monitors the power.

3. The power monitoring system according to claim 1, wherein the server collects the first power amount data, the second power amount data and the third power amount data and monitors the power based on the collected power amount data.

4. The power monitoring system according to claim 1, wherein the renewable energy source is a solar power generator (140).

5. The power monitoring system according to claim 1, wherein the second power amount data includes a power consumption pattern of the loads, and
wherein the server uses the power consumption pattern of the loads to acquire the amount of power consumed by the loads.

6. The power monitoring system according to claim 5, wherein the server acquires the amount of power consumed by the loads by using a Non-Intrusive Load Monitoring, NILM, algorithm to analyze the second power amount data.

7. The power monitoring system according to claim 1, wherein the server includes:
a communication unit (11) configured to collect at least one of the first power amount data, the second power amount data and the third power amount data;
a control unit (12) configured to use the collected power amount data to monitor the power;
a storage unit (13) configured to store a result of the monitoring; and
an output unit (14) configured to output the result of the monitoring.

8. A power monitoring system comprising:
an external power supply source (110) configured to generate and supply power;
a distribution board (120) configured to distribute power, which is applied from the external power supply source (110), to loads;
a renewable energy source connected to an output terminal of the distribution board (120) and configured to generate power and apply the generated power to the loads through the distribution board (120);
a first power measuring device connected to an output terminal of the external power supply source (110) and configured to sense first power amount data including at least one of the amount of power applied from the external power supply source (110) and the amount of power distributed to the loads;
a second power measuring device connected to an input terminal of the distribution board (120) and configured to sense second power amount data including at least one of the amount of power applied from the external power supply source (110) and the amount of power distributed to the loads;
a third power measuring device connected to an output terminal of the renewable energy source and configured to sense third power amount data applied from the renewable energy source; and
a server configured to monitor power based on at least one of the first power amount data and the second power amount data, and the third power amount data,
wherein the server collects the first power amount data and the third power amount data, estimates the second power amount data based on the collected power amount data, and monitors the power.

9. The power monitoring system according to claim 8, wherein the server collects the second power amount data and the third power amount data, estimates the first power amount data based on the collected power amount data, and monitors the power.

10. The power monitoring system according to claim 8, wherein the server collects the first power amount data, the second power amount data and the third power amount data and monitors the power based on the collected power amount data.

11. The power monitoring system according to claim 8, wherein the renewable energy source is a solar power generator (140).

12. The power monitoring system according to claim 8, wherein each of the first power amount data and the second power amount data includes a power consumption pattern of the loads, and
wherein the server uses the power consumption pattern of the loads, which is included in at least one of the first power amount data and the second power amount data, to acquire the amount of power consumed by the loads.

13. The power monitoring system according to claim 12, wherein the server acquires the amount of power consumed by the loads by using a Non-Intrusive Load Monitoring, NILM, algorithm to analyze at least one of the first power amount data and the second power amount data.

14. The power monitoring system according to claim 8, wherein the server includes:
a communication unit (11) configured to collect power amount data from at least one of the first power measuring device, the second power measuring device and the third power measuring device;
a control unit (12) configured to use the collected power amount data to monitor the power;
a storage unit (13) configured to store a result of the monitoring; and
an output unit (14) configured to output the result of the monitoring.
